# EUROPÄISCHE PATENTSCHRIFT

(11) **EP 3 657 288 B1**
(45) Veröffentlichungstag und Bekanntmachung des Hinweises auf die Patenterteilung: **06.04.2022**
(21) Anmeldenummer: 19211494.0
(22) Anmeldetag: 26.11.2019
(51) Int. Cl.: G05B 23/02, H02H 3/20, G06F 1/30

(54) **SICHERE SPANNUNGSÜBERWACHUNG**
SAFE VOLTAGE MONITORING
SURVEILLANCE SÉCURISÉE DE LA TENSION

(30) Priorität: 26.11.2018 DE 102018129796
(43) Veröffentlichungstag der Anmeldung: 27.05.2020
(73) Patentinhaber: Pilz GmbH & Co. KG, 73760 Ostfildern (DE)
(72) Erfinder: Bakovic, Daniel, 73760 Ostfildern (DE); Schweiker, Matthias, 73760 Ostfildern (DE); Schoch, Uwe, 73760 Ostfildern (DE); Pullmann, Jürgen, 73760 Ostfildern (DE)
(74) Vertreter: Witte, Weller & Partner Patentanwälte mbB

(56) Entgegenhaltungen:
- EP-A1- 0 614 049
- EP-A1- 2 182 604
- EP-A2- 2 117 094
- EP-B1- 0 614 049

## Beschreibung

Die vorliegende Erfindung betrifft eine Vorrichtung und ein Verfahren zur Spannungsüberwachung einer Einrichtung, die eine Sicherheitsfunktion einer Maschine oder technischen Anlage realisiert oder überwacht und mindestens zwei Verarbeitungskanäle aufweist, sowie eine entsprechende Einrichtung hierfür.

In der industriellen Automatisierungs- oder Prozesstechnik sind Einrichtungen vorzusehen, die dazu dienen, ein Risiko, welches von technischen Anlagen für Menschen und Umwelt ausgeht, zu reduzieren. Hierzu werden Sicherheitsfunktionen implementiert, die eingerichtet sind bei einer Gefahr, eine technische Anlage oder einen sicherheitskritischen Prozess in einen sicheren Zustand zu überführen. Unter dem Begriff der Sicherheitsfunktion definieren die einschlägigen Normen DIN EN ISO 13849-1 und DIN EN ISO 12100 eine sicherheitsgerichtete Steuerfunktion einer Maschine, die ein von der Maschine ausgehendes Risiko auf ein akzeptables Maß reduziert. Eine Sicherheitsfunktion ist beispielsweise die Abschaltung einer Maschine nach Drücken eines Not-Aus-Tasters.

Ursprünglich wurden Sicherheitsfunktionen zunächst durch einzelne sichere Baugruppen beispielsweise in Form von Sicherheitsschaltgeräten mit Relaistechnik realisiert. Diese wurden und werden heute noch unabhängig von einer Steuerung der zu überwachenden Anlage eingesetzt. Sie agieren im Wesentlichen selbständig und unabhängig von der Steuerung und schalten im Gefahrenfall die technische Anlage durch Trennen einer Spannungsversorgung ab. In der Weiterentwicklung wurden Sicherheitsschaltgeräte anschließend logisch miteinander verknüpft, um auch komplexere Sicherheitsfunktionen zu realisieren. Für noch komplexere Aufgaben werden heutzutage Sicherheitssteuerungen eingesetzt, die Sicherheit ähnlich wie bei einer speicherprogrammierbaren Steuerung (SPS-Steuerung) durch Programmierung verschalten können. Eine Sicherheitssteuerung unterscheidet sich dabei von einer SPS-Steuerung regelmäßig durch zwei getrennte Kanäle, einen diversitären Aufbau mit unterschiedlicher Hardware, ständigen Tests der Ein- und Ausgänge, ständigen Vergleich der Anwenderdaten, einer Spannungs- und Zeitüberwachung sowie einer sicheren Abschaltung im Fehler-/Gefahrenfall.

Im Sinne der vorliegenden Offenbarung sind Sicherheitsschaltgeräte, konfigurierbare Sicherheitsschaltgeräte und Sicherheitssteuerungen allesamt als sichere Einrichtungen zu verstehen. Zur Versorgung der elektrischen Bauteile dieser sicheren Einrichtungen, insbesondere der Versorgung der zumeist als Mikrocontroller ausgebildeten Verarbeitungseinheiten, weisen die sicheren Einrichtungen Spannungsregulatoren auf, die eine extern bereitgestellte Versorgungsspannung, beispielsweise 24 Volt, in kleinere Betriebsspannungen, beispielsweise 3,3 Volt, 5 Volt, 12 Volt oder 24 Volt umwandeln, je nachdem welche Betriebsspannung für den Betrieb der elektrischen Bauteile notwendig ist.

Bei digitalen Systemen wie Mikrocomputern und Mikroprozessoren ist es dabei wichtig, dass sie nur dann in einen aktiven Zustand versetzt werden, wenn ihre Betriebsspannung sich auf ihrem Sollwert befindet. Ein Absinken oder Zusammenbrechen der Betriebsspannung kann zu einem fehlerhaften Arbeiten dieser Systeme führen und damit die bereitgestellte Sicherheitsfunktion beeinträchtigen.

Eine sichere Spannungsüberwachung ist daher ein wesentlicher Bestandteil aller sicheren Einrichtungen und grundsätzlich in ein Sicherheitskonzept zu integrieren. Umso wichtiger ist es daher, ein Spannungsüberwachungskonzept bereitzustellen, welches sehr einfach gehalten ist, sich kostengünstig implementieren lässt und darüber hinaus eine hohe Zuverlässigkeit aufweist.

EP 0 614 049 A1 zeigt eine selbstüberwachende Netzteileinheit mit einem Überspannungswächter und einem Unterspannungswächter, die durch Anlegen eines Testsignals periodisch auf Funktionsfähigkeit überprüft werden. Es wird der Fehlerfall simuliert, indem das Testsignal den Spannungswächtern eine Über- bzw. Unterspannung vortäuscht. Die Wächter sprechen daraufhin an und melden dies der Rechnereinheit, die das Testsignal sofort wieder deaktiviert.

EP 2 117 094 A2 zeigt eine Schaltungsanordnung zum Überwachen einer Spannung mit einer Komparatorschaltung, mit der wenigstens ein von der zu überwachenden Spannung abgeleitetes Potenzial mit einem Referenzpotenzial vergleichbar ist, um eine Fehlspannung festzustellen, wobei eines der Potenziale an einem Spannungsteiler abgegriffen wird, der eine Reihenschaltung aus wenigstens zwei Widerständen umfasst. Zur Prüfung der Schaltungsanordnung wird vorgeschlagen, dass ein Widerstand innerhalb des Spannungsteilers derart veränderbar ist, dass eine Fehlspannung simuliert werden kann.

EP 2 182 604 A1 zeigt eine Stromversorgungsüberwachungsschaltung, die eine Stromversorgung überwacht, und dabei selbst von einer Überwachungsschaltung überwacht wird. Die Überwachungsschaltung ist mit einem Spannungsreferenzeingang der Stromversorgungsüberwachungsschaltung gekoppelt und eingerichtet, die Spannung an diesem Eingang zu variieren. Ferner ist die Überwachungsschaltung mit einem Status-Ausgang der Stromversorgungsüberwachungsschaltung gekoppelt, um eine Fehleranzeige zu überwachen.

Vor diesem Hintergrund ist es eine Aufgabe der vorliegenden Offenbarung, ein entsprechendes Spannungsüberwachungskonzept sowie dafür notwendige Vorrichtungen und Verfahren anzugeben, welche sehr einfach gehalten und zuverlässig sind und kostengünstig implementiert werden können.

Gemäß einem Aspekt der vorliegenden Offenbarung wird diese Aufgabe gelöst durch eine Vorrichtung zur Spannungsüberwachung gemäß Anspruch 1.

Gemäß einem weiteren Aspekt wird die Aufgabe ferner gelöst durch ein Verfahren zur Spannungsüberwachung gemäß Anspruch 14.

Es ist somit eine Idee der vorliegenden Erfindung, einen Spannungsregler einkanalig mit einem Spannungsmonitor zu überwachen. Der Spannungsmonitor selbst wird wiederum zweikanalig getestet. Die Spannungsüberwachung kann so besonders sicher implementiert werden und auch den Anforderungen höherer Sicherheitskategorien der eingangs genannten Sicherheitsnormen genügen.

Gleichzeitig lassen sich die zusätzlichen Tests der Spannungsüberwachung günstig realisieren, da auf die zweikanalige Verarbeitung der sicheren Einrichtung zurückgegriffen werden kann. Insbesondere kann so eine redundante Auslegung der Spannungsversorgung selbst bzw. deren Überwachung vermieden werden, wodurch Kosten eingespart werden können.

Durch Schnittstellen, die direkt mit den Spannungsregler gekoppelt sind, können die Tests auf einfache Weise direkt an den zur Spannungsüberwachung verwendeten Komponenten durchgeführt werden. Das Durchführen der Tests kann mit geringem Aufwand der sicheren Einrichtung erfolgen und ist daher auch von leistungsschwächeren Verarbeitungseinheiten durchführbar. Die Vorrichtung kann somit für unterschiedliche sichere Einrichtung von einem einfachen Schaltgerät bis hin zur programmierbaren, sicheren Steuerung flexibel eingesetzt werden. Die eingangs genannte Aufgabe ist damit vollständig gelöst.

In einer weiteren Ausgestaltung führt ein Abschalten des Ausgangs durch den Spannungsmonitor zum Ausführen der Sicherheitsfunktion. Indem das Abschalten des Ausgangs dazu führt, dass die Sicherheitsfunktion ausgeführt wird, kann die Spannungsüberwachung sowie deren Überprüfung einfach realisiert werden, da im Fehlerfall nur der Ausgang abgeschaltet werden muss, um einen sicheren Zustand herbeizuführen. Das heißt, es muss kein zusätzlicher Abschaltpfad realisiert werden, noch muss der Spannungsüberwachung die Realisierung der Sicherheitsfunktion bekannt sein. Die Spannungsüberwachung kann so besonders einfach gehalten werden.

In einer weiteren Ausgestaltung ist der Spannungsregler mit einem Widerstandsnetzwerk gekoppelt und das Verstimmen des Spannungsreglers beinhaltet, die definierte Ausgangsspannung des Spannungsreglers über das Widerstandsnetzwerk einzustellen. Ein Widerstandsnetzwerk, welches je nach Beschaltung verschiedene Widerstandswerte an definierten Anschlüssen bereitstellt, kann besonders leicht und kostengünstig realisiert werden. Auf diese Weise kann ein Verstimmen des Spannungsreglers besonders einfach erfolgen. Diese Ausgestaltung trägt somit weiter zu einer Kostenreduzierung der Vorrichtung bei.

In einer weiteren Ausgestaltung weist die Vorrichtung ferner ein erstes und ein zweites Schaltelement auf, die je in Abhängigkeit eines an der ersten oder zweiten Schnittstelle anliegenden Signals betätigbar sind, wobei das Verstimmen des Spannungsreglers durch das Betätigen des ersten oder des zweiten Schaltelements erfolgt. Schaltelemente können einfach betätigt werden und haben geringe Anforderungen an die sie ansteuernden Signale. Das Verstimmen des Spannungsreglers kann so besonders einfach erfolgen, ohne dass ein komplexes Ansteuersignal verwendet werden muss. Dies ermöglicht zudem, dass die Tests der Spannungsüberwachung auch von einfach ausgebildeten sicheren Einrichtungen durchgeführt werden können und nur geringe Anforderungen an die Leistungsfähigkeit der innerhalb der Verarbeitungskanäle verwendeten Verarbeitungseinheiten gestellt sind.

Besonders bevorzugt ändert das Betätigen des ersten und des zweiten Schaltelements die am Ausgang anliegende Spannung um einen definierten Betrag. Indem die Schaltelemente die am Ausgang anliegende Spannung um einen definierten Betrag ändern, kann auf einfache Weise eine Unter- bzw. eine Überspannung zu Testzwecken eingestellt werden.

Dies erfolgt besonders bevorzugt, indem der Spannungsregler die definierte Ausgangsspannung bereitstellt, wenn das erste Schaltelement betätigt ist und das zweite Schaltelement nicht betätigt ist, der Spannungsregler eine definierte Unterspannung, welche kleiner als die definierte Ausgangsspannung, bereitstellt, wenn das erste und das zweite Schaltelement betätigt sind, und der Spannungsregler eine definierte Überspannung, welche größer als die definierte Ausgangsspannung ist, bereitstellt, wenn das erste Schaltelement nicht betätigt ist und das zweite Schaltelement betätigt ist. Durch diese Verknüpfung der durch die zwei Verarbeitungskanäle getrennt ansteuerbaren Schaltelemente kann auf einfache Weise sowohl eine Unterspannung als auch eine Überspannung erzeugt werden. Das Ansteuern der Schnittstellen und das Durchführen der Tests kann so besonders einfach realisiert werden.

In einer weiteren Ausgestaltung weist die Vorrichtung ferner einen Kondensator auf, der am Ausgang angeordnet ist und dazu eingerichtet ist, die definierte Ausgangsspannung über eine definierte Zeitspanne zu halten, wenn der Spannungsmonitor den Ausgang abschaltet. Der Kondensator hat als Pufferkondensator bewirkt, dass beim Abschalten des Ausgangs eine anliegende Spannung nicht unmittelbar abfällt, sondern für einen definierten Zeitraum weiter abgegriffen werden kann. Auf diese Weise ist es möglich, dass ein Test durchgeführt werden kann, der im ordnungsgemäßen Betrieb dazu führen würde, dass der Ausgang abgeschaltet wird. Durch den Kondensator jedoch führt das Abschalten nicht zum tatsächlichen Ausführen der Sicherheitsfunktion, bspw. dem Abschalten des Systems, wodurch die Verfügbarkeit der sicheren Einrichtung durch die Tests nicht beeinträchtigt wird.

In einer weiteren Ausgestaltung weist die Vorrichtung ferner eine dritte und eine vierte Schnittstelle auf, die mit dem ersten und dem zweiten Verarbeitungskanal getrennt voneinander koppelbar sind und an denen die am Ausgang anliegende Spannung abgreifbar ist. Das getrennte Abgreifen der am Ausgang anliegenden Spannung ermöglicht ein zweikanaliges Zurücklesen, so dass auch die Auswertung der Tests zweikanalig durch die beiden vorhandenen Verarbeitungskanäle erfolgen kann.

In einer weiteren Ausgestaltung kann die Einrichtung eine Kommunikationsschnittstelle, bspw. eine USB-Schnittstelle aufweisen, die eine Betriebsspannung als Eingangsspannung bereitstellt und über die vorzugsweise die Realisierung oder Überwachung der Sicherheitsfunktion erfolgt. Diese Ausgestaltung ist besonders vorteilhaft bei einfachen sicheren Einrichtungen, die bspw. nur dazu ausgelegt sind, eine andere Einrichtung zu überwachen. Indem die Betriebsspannung von einer Kommunikationsschnittstelle, wie beispielsweise einer USB-Schnittstelle, bereitgestellt wird, kann die Einrichtung mit einer einzigen Schnittstelle auskommen, wodurch die Implementierung der Einrichtung vereinfacht wird.

Besonders bevorzugt ist die Einrichtung eine Überwachungseinrichtung, die als Dongle, insbesondere als USB-Stick, ausgebildet ist und ein Gehäuse umfasst, in dem ein erster und zweiter Mikrocontroller als Verarbeitungseinheiten eingefasst sind. Eine solche Einrichtung kann dazu ausgebildet sein, die Ausführung einer aus Anwenderprogrammen realisierten Sicherheitsfunktion auf einer Plattform zu sichern, wobei die Überwachungseinrichtung über eine erste Kommunikationsschnittstelle mit der Plattform koppelbar ist und mindestens einen fehlersicheren Dienst unabhängig von der Plattform ausführt, über den die Überwachungseinrichtung mit einer fehlersicheren Peripheriebaugruppe zusammenwirkt, so dass die fehlersichere Peripheriebaugruppe in Abhängigkeit von der realisierten Sicherheitsfunktion auf der Plattform und dem fehlersicheren Dienst einen sicheren Zustand der Maschine oder technischen Anlage herbeiführt. Diese Ausgestaltung ist besonders vorteilhaft, da die sichere Einrichtung insgesamt auf mehrere Komponenten verteilt werde kann. Dies bewirkt, dass eine effektive Ausführung einer insbesondere in Software realisierten Sicherheitsfunktion durch eine leistungsstarke, jedoch nicht zwangsläufig eigensichere, Plattform erfolgen kann, während die sicherheitstechnische Absicherung in einfache, aber fehlersichere, Peripheriegeräte verlagert wird, die mit der Plattform zusammenwirken.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung dargestellt und werden in der nachfolgenden Beschreibung näher erläutert. Es zeigen:
- Fig. 1: eine sichere Einrichtung mit einem Ausführungsbeispiel der Vorrichtung;
- Fig. 2: eine bevorzugte Implementierung eines Ausführungsbeispiels der Vorrichtung;
- Fig. 3: ein bevorzugtes Anwendungsszenario mit Ausführungsbeispielen der Vorrichtung; und
- Fig. 4: ein Flussdiagramm eines Ausführungsbeispiels des Verfahrens.

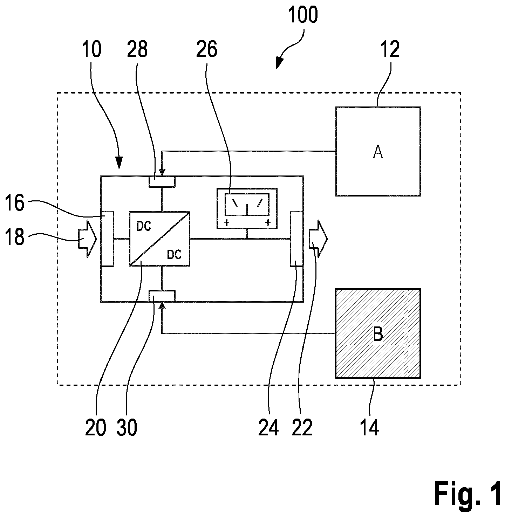

Fig. 1 zeigt eine sichere Einrichtung, in der ein Ausführungsbeispiel der neuen Vorrichtung implementiert ist. Die sichere Einrichtung ist in ihrer Gesamtheit in der Fig. 1 mit der Bezugsziffer 100 bezeichnet und die neue Vorrichtung mit der Bezugsziffer 10.

Die sichere Einrichtung 100 implementiert eine Sicherheitsfunktion zur Absicherung einer technischen Anlage oder eines sicherheitskritischen Prozesses (hier nicht dargestellt). Unter dem Begriff der Sicherheitsfunktion versteht man eine sicherheitsgerichtete Steuerungsfunktion, die im Gefahrenfall manuell oder automatisiert ausgeführt wird, um eine Maschine oder einen sicherheitskritischen Prozess in einen sicheren Zustand zu überführen. Eine Sicherheitsfunktion ist beispielsweise die Abschaltung einer Maschine nach Drücken eines Not-Aus-Tasters.

Die Verarbeitung der Sicherheitsfunktion erfolgt redundant in zwei sich vorzugsweise gegenseitig überwachenden Verarbeitungskanälen 12, 14. Die Kanäle sind hier als A-Kanal und B-Kanal bezeichnet. Die Verarbeitung kann bspw. durch das parallele und getrennte Ausführen von Anwenderprogrammen auf Verarbeitungseinheiten, insbesondere Mikrocontrollern, der Verarbeitungskanäle erfolgen.

Der Betrieb der elektrischen Bauteile der sicheren Einrichtung erfordert eine sichere Spannungsversorgung, die hier durch ein Ausführungsbeispiel der neuen Vorrichtung 10 realisiert wird. Die Vorrichtung 10 kann wie hier dargestellt in der sicheren Einrichtung 100 integriert sein und von dem umschließenden Gehäuse der sicheren Einrichtung 100 umfasst sein, sodass die sichere Einrichtung 100 mit der neuen Vorrichtung 10 äußerlich eine Einheit bilden. In einem anderen Ausführungsbeispiel kann die Vorrichtung auch eine eigenständige Einheit mit einem eigenen Gehäuse sein, die über eine oder mehrere Schnittstellen mit der sicheren Einrichtung 100, insbesondere den Verarbeitungskanälen und einer Spannungsversorgung der sicheren Einrichtung 100 gekoppelt ist.

Die Vorrichtung 10 weist mindestens einen Eingang 16 auf, über den die Vorrichtung 10 eine Eingangsspannung 18 aufnehmen kann. Die Eingangsspannung 18 kann eine Versorgungsspannung der sicheren Einrichtung sein, beispielsweise die in der Automatisierungstechnik häufig verwendete Versorgungsspannung von 24 V, oder eine jede andere Gleich- oder Wechselspannung.

Die wesentliche Aufgabe der Vorrichtung 10 ist es, die anliegende Eingangsspannung über einen Spannungsregler 20 in eine definierte Ausgangsspannung 22 umzuformen, die vorzugsweise konstant, d.h. sowohl unabhängig von der Eingangsspannung 18, als auch stabil, d.h. unabhängig von der Stromaufnahme, ist. Im normalen Betrieb erzeugt der Spannungsregler 20 eine definierte Ausgangsspannung 22, die der Betriebsspannung der sicheren Einrichtung 100 entspricht und geeignet ist, die in der sicheren Einrichtung 100 verwendeten elektrischen Bauteil zu betreiben. Ein Arbeitspunkt dieser elektrischen Bauteile kann beispielsweise bei 3,3V liegen. Es versteht sich, dass in einem anderen Ausführungsbeispiel die sichere Einrichtung mehrere verschiedene Betriebsspannungen zum Betrieb benötigen kann und diese als Ausgangspannungen der neuen Vorrichtung bereitstellt werden können. Jede einzelne Ausgangspannung kann dann in der nachfolgend beschriebenen Weise überwacht werden.

Die Ausgangsspannung wird an einem Ausgang 24 bereitgestellt und gleichzeitig von einem Spannungsmonitor 26 überwacht. Der Spannungsmonitor 26 ist ausgebildet, sobald die gemessene Spannung am Ausgang 24 um einen definierten Betrag von der definierten Ausgangsspannung abweicht, den Ausgang abzuschalten. Mit anderen Worten, wenn die definierte Ausgangsspannung wegen einer Über- oder einer Unterspannung nicht bereitgestellt werden kann, liegt am Ausgang keine Spannung an, wodurch die sichere Einrichtung veranlasst ist, den durch die Sicherheitsfunktion definierten sicheren Zustand einzustellen, also bspw. die zu überwachende technische Anlage stillzusetzten. Auf diese Weise kann sichergestellt werden, dass die elektrischen Bauteile der sicheren Einrichtung 100 ausschließlich mit der für den Betrieb notwendigen Betriebsspannung versorgt werden.

Um die Funktionsfähigkeit des Spannungsmonitor 26 sicherzustellen, muss dieser durch Tests überprüfbar sein. Die Vorrichtung 10 weist hierfür einen Spannungsregler 20 auf, der einstellbar ist, d.h. dessen Ausgangsspannung durch eine spezifische Ansteuerung veränderbar ist. Zusätzlich weist die Vorrichtung 10 eine erste und eine zweite Schnittstelle 28, 30 auf, über die der Spannungsregler 20 mit den beiden Verarbeitungskanälen 12, 14 der sicheren Einrichtung 100 koppelbar ist.

Über die Schnittstellen 28, 30 kann der Spannungsregler 20 "verstimmt" werden, d.h. eine Ansteuerung des Spannungsreglers 20 kann so über die erste und die zweite Schnittstelle 28, 30 erfolgen, dass einerseits eine Unterspannung, die kleiner ist als die definierte Ausgangsspannung, und andererseits eine Überspannung, die größer ist als die definierte Ausgangsspannung, vom Spannungsregler 20 bereitgestellt wird.

Die Über- bzw. Unterspannung ist dabei so gewählt, dass ein Anliegen dieser Spannungen am Ausgang 24 der Vorrichtung zu einem Ansprechen des Spannungsmonitors 26 führt. Mit anderen Worten können die Verarbeitungskanäle 12, 14, d.h. insbesondere die im jeweiligen Kanal ausgeführten Anwenderprogramme, unabhängig voneinander den Spannungsregler 20 so einstellen, dass der Spannungsmonitor 26, wenn dieser ordnungsgemäß funktioniert, den Ausgang 24 abschaltet. Auf diese Weise kann der Spannungsmonitor 26 unabhängig und durch den Rückgriff auf die beiden Verarbeitungskanäle redundant getestet werden.

Durch die dedizierte Ansteuerung des Spannungsreglers 20 kann somit die Funktionsfähigkeit der Spannungsüberwachung durch den Spannungsmonitor 26 getestet werden, wodurch eine fehlerhafte Spannungsüberwachung identifiziert werden kann. Die Eigenfehlersicherheit der sicheren Einrichtung 100 kann auf diese Weise vorteilhaft erhöht werden. Durch den Rückgriff auf die vorhandenen Verarbeitungskanäle der sicheren Einrichtung 100 kann der Selbsttest der Spannungsüberwachung zudem effektiv und kostengünstig realisiert werden.

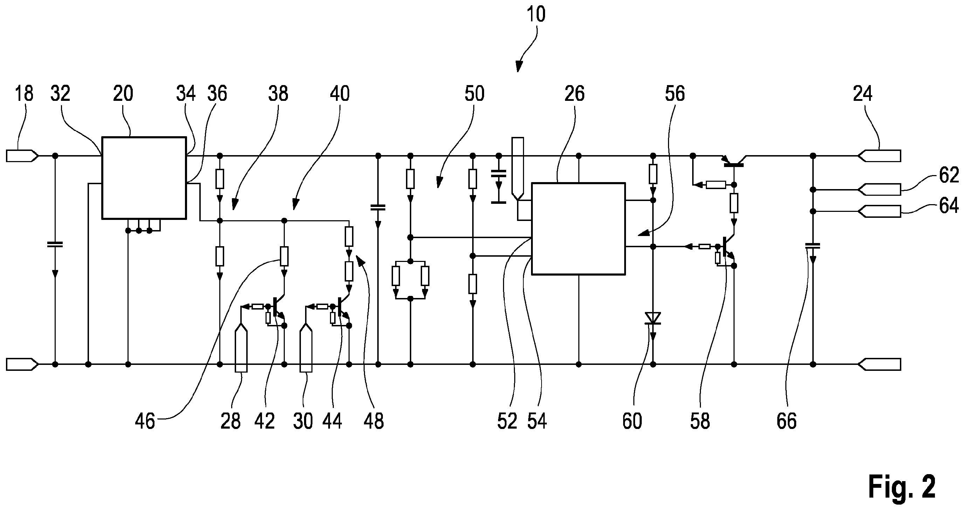

Eine bevorzugte Implementierung eines Ausführungsbeispiels der Vorrichtung ist in der Fig. 2 dargestellt. Fig. 2 zeigt die neue Vorrichtung als Schaltungsdiagramm. Gleiche Bezugszeichen bezeichnen gleiche Teile wie zuvor in Bezug auf Fig. 1.

Der Spannungsregler 20 ist in diesem Ausführungsbeispiel ein als integrierte Schaltung ausgebildeter Längsregler. Über einen ersten Anschluss 32 wird dem Spannungsregler 20 eine Eingangsspannung 18 zugeführt. An einem zweiten Anschluss 34 kann die gewandelte definierte Ausgangsspannung 22 abgegriffen werden. Ein dritter Anschluss 36 wiederum dient der spezifischen Ansteuerung des Spannungsreglers 20, über die die bereitgestellte Ausgangsspannung am zweiten Anschluss 34 einstellbar ist. Für die Einstellung wird über den Spannungsteiler 38 eine Steuerspannung am dritten Anschluss 36 angelegt. Die Steuerspannung ist in diesem Ausführungsbeispiel über ein Widerstandsnetzwerk 40 einstellbar, indem gezielt Widerstände zu dem Spannungsteiler 38 hinzugefügt oder entfernt werden.

Das Hinzufügen und das Entfernen von Widerständen erfolgt hier über ein erstes und ein zweites Schaltelement 42, 44. Das erste Schaltelement 42 schaltet einen ersten Widerstand 46 parallel zu einem Widerstand des Spannungsteilers 38 und das zweite Schaltelement 44 schaltet einen zweiten Widerstand 48 unabhängig von dem ersten Widerstand 46 parallel zum Widerstand des Spannungsteilers 38. Über das Hinzuschalten bzw. das Entfernen der Widerstände vom Gesamtwiderstand des Spannungsteilers 38 kann eine Steuerspannung an dem dritten Anschluss 36 verändert werden, wodurch die am zweiten Anschluss 34 bereitgestellte Ausgangsspannung "manipuliert" wird. Insbesondere können je nach Schalterstellung des ersten und zweiten Schaltelements 42, 44 eine definierte Überspannung bzw. eine definierte Unterspannung am zweiten Anschluss 34 eingestellt werden.

Das erste Schaltelement 42 ist hier mit einer ersten Schnittstelle 28 verbunden und das zweite Schaltelement 44 ist mit einer zweiten Schnittstelle 30 verbunden. Über die Schnittstellen 28, 30 können die Schaltelemente 42, 44 wahlweise betätigt werden. Es besteht somit die Möglichkeit, über die beiden Schnittstellen 28, 30 eine definierte Unterspannung bzw. Überspannung einzustellen. Der erste Widerstand 46, der zweite Widerstand 48 und der Spannungsteiler 38 sind dabei vorzugsweise so ausgebildet, dass, wenn das erste Schaltelement 42 nicht betätigt ist und das zweite Schaltelement44 betätigt ist, am zweiten Anschluss 34 die definierte Ausgangsspannung, beispielsweise 3,6 V, anliegt. Sind hingegen das erste Schaltelement 42 und das zweite Schaltelement 44 beide betätigt, stellt sich am zweiten Anschluss 34 eine Unterspannung ein, beispielsweise eine Spannung kleiner 3,2 V. Ist wiederum das erste Schaltelement 42 betätigt und das zweite Schaltelement 44 nicht betätigt, stellt sich am zweiten Anschluss 34 eine Überspannung ein, die beispielsweise oberhalb von 3,9 V liegt.

Es versteht sich, dass die hier gezeigte Implementierung nur eine Möglichkeit ist, eine Unter- oder Überspannung bezogen auf die definierte Ausgangsspannung zu erzeugen. In anderen Ausführungsbeispielen kann der Spannungsregler 20 auch anderweitig direkt oder indirekt ansteuerbar sein, um "verstimmt" zu werden. Entscheidend ist, dass die Ansteuerung unabhängig durch die mindestens zwei Verarbeitungskanäle erfolgen kann, um eine redundanten Test zu ermöglichen.

Die Über- bzw. Unterspannung kann von dem Spannungsmonitor 26 erfasst werden. Der Spannungsmonitor 26 ist in diesem bevorzugten Ausführungsbeispiel ebenfalls als eine integrierte Schaltung ausgebildet. Im Prinzip kann es sich bei dem Spannungsmonitor 26 um zwei Schwellwertschalter handeln, die beim Überschreiten eines ersten Schwellwerts, d.h. bei einer Überspannung, bzw. beim Unterschreiten eines zweiten Schwellwerts, d.h. beim Anliegen einer Unterspannung, eine Aktion ausführen bzw. einen Ausgangsanschluss schalten. Die Aktion kann insbesondere das Abschalten des Ausgangs 24 bewirken.

Die Schwellwerte für die Über- und Unterspannung werden hier durch ein weiteres Widerstandsnetzwerk 50 in Abhängigkeit zu der am zweiten Anschluss 34 bereitgestellten Ausgangsspannung definiert und an einem ersten und zweiten Eingangsanschluss 52, 54 dem Spannungsmonitor 26 bereitgestellt. Über weitere Ausgangsanschlüsse 56 des Spannungsmonitors 26 wird die Aktion ausgeführt. Im hier dargestellten Ausführungsbeispiel steuern die Ausgangsanschlüsse 56 ein weiteres Schaltelement 58 an, über welches der Ausgang 24 vom zweiten Anschluss 34 des Spannungsreglers 20 getrennt werden kann.

Es versteht sich, dass die Spannungsüberwachung nicht durch eine integrierte Schaltung, wie es in Fig. 2 angedeutet ist, erfolgen muss. Andere Ausführungen des Spannungsmonitors, bspw. mit diskreten Bauelementen, sind denkbar.

Der Zustand der Ausgangsanschlüsse 56 kann wie in diesem Ausführungsbeispiel über eine Leuchtdiode 60 sichtbar gemacht werden. Darüber hinaus kann eine dritte und vierte Schnittstelle 62, 64 vorgesehen sein, über die die am Ausgang 24 anliegende Spannung unabhängig abgegriffen werden kann. Dies ermöglicht ein getrenntes Rücklesen des Ausgangs 24 durch den ersten und zweiten Verarbeitungskanal 12, 14.

Vorzugsweise ist die sichere Einrichtung somit über die erste, zweite, dritte und vierte Schnittstelle 28, 30, 62, 64 mit der Vorrichtung 10 gekoppelt. Die erste und dritte Schnittstelle 28, 62 sind mit einem ersten Verarbeitungskanal 12 der sicheren Einrichtung 100 gekoppelt und die zweite und vierte Schnittstelle 30, 64 sind mit einem zweiten Verarbeitungskanal 14 der sicheren Einrichtung 100 gekoppelt. Der Spannungsmonitor 26 kann so zweikanalig getestet und die Testergebnisse zweikanalig zurückgelesen werden, während der Spannungsmonitor 26 selbst einkanalig ausgebildet ist.

Das zweikanalige Testen erfolgt, indem die sichere Einrichtung 100 das erste und das zweite Schaltelement 42, 44 in der zuvor beschriebenen Weise betätigt und gezielte Überspannungen und Unterspannungen für einen definierten Zeitraum erzeugt. Über die dritte und vierte Schnittstelle 62, 64 können die Verarbeitungskanäle 12, 14 ergänzend unabhängig voneinander den am Ausgang anliegenden Spannungswert zurücklesen, um zu überprüfen, ob der Spannungsmonitor 26 erwartungsgemäß auf das Verstimmen des Spannungsreglers 20 reagiert. Es versteht sich, dass anstelle des zweikanaligen Rücklesens auch eine direkte Ausführung der Sicherheitsfunktion durch den Spannungsmonitor 26 erfolgen kann.

Die Tests durch Anlegen der Überspannung bzw. Unterspannung führen im ordnungsgemäßen Betrieb des Spannungsmonitor 26 zum Abschalten des Ausgangs 24, was wiederum das Einstellen eines sicheren Zustands durch die sichere Einrichtung 100 bewirkt. Damit die Test nicht zum tatsächlichen Ausführen der Sicherheitsfunktion führen, kann in einem bevorzugten Ausführungsbeispiel am Ausgang 24 ein zusätzlicher Kondensator 66 angeordnet sein, der die am Ausgang 24 anliegende Spannung für eine definierte Zeitspanne, mindestens jedoch für den definierten Zeitraum der Über- bzw. Unterspannung, puffert. Bspw. kann die Kapazität so dimensioniert sein, dass eine abgeschaltete Ausgangsspannung für 10 ms überbrückt wird.

Das Rücklesen des Ausgangs 24 durch die sichere Einrichtung erfolgt dann basierend auf einem Entladeverhalten des Kondensators und kann zur genaueren Bestimmung auch explizit an das Entladeverhalten des Kondensators angepasst sein. Mit anderen Worten kann ein erfolgreicher Test, nicht nur daran geknüpft werden, dass sich der Kondensator 66 entlädt, sondern auch daran, ob sich dieser erwartungsgemäß entlädt.

Es versteht sich, dass der Kondensator 66 nur eine Möglichkeit darstellt, eine Spannungsversorgung am Ausgang 24 zu überbrücken. Alternativ können auch andere Energiespeicher in Kombination mit einer geeigneten Wahl der jeweiligen Testdauer bzw. Testperiode eingesetzt werden. Eine Überbrückung mittels Kondensator 66 kann jedoch sehr kostengünstig realisiert und robust implementiert werden.

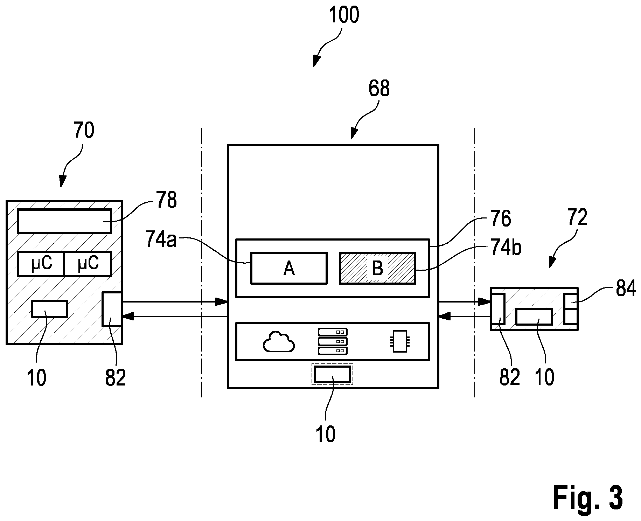

Fig. 3 zeigt ein bevorzugtes Anwendungsszenario, in dem Vorrichtungen gemäß der vorliegenden Offenbarung zum Einsatz kommen können. Gleiche Bezugszeichen bezeichnen auch hier wieder gleiche Teile wie in den Ausführungen zuvor.

Fig. 3 zeigt eine sichere Einrichtung 100, die sich hier aus drei einzelnen, voneinander getrennten Komponenten zusammensetzt. Die drei Komponenten umfassen eine Plattform 68, eine Überwachungseinrichtung 70 sowie eine fehlersichere Peripheriebaugruppe 72. Ziel der Aufteilung der sicheren Einrichtung 100 in getrennte Komponenten ist es, eine vorwiegend in Software realisierte Sicherheitsfunktion auf einer beliebigen, insbesondere nicht sicheren, Plattform 68 auszuführen, während die maßgebliche Absicherung der Ausführung durch Plattform-externe Komponenten erfolgt. Diese für die Sicherheit maßgeblichen und insbesondere als dedizierte Hardware implementierten externen Komponenten können so einfach wie möglich ausgestaltet sein, um kostenbewusst implementiert zu werden. Gleichzeitig kann ein Verwaltungsaufwand für eine normgerechte Zertifizierung für diese Komponenten gering gehalten werden.

Insgesamt kann die sichere Einrichtung 100 so auch sehr komplexe Sicherheitsfunktionen günstig realisieren, da die Sicherheit in separaten Komponenten "gekapselt" ist. Mit anderen Worten ist es möglich, die komplexe Ausgestaltung einer Sicherheitsfunktion überwiegend in Software auf einer günstigen Plattform zu realisieren und die benötigte Eigenfehlersicherheit in einfach zu implementierende, und damit auch mit geringem Aufwand zertifizierbare, Komponenten auszulagern.

Die Plattform-externen Komponente, d.h. die Überwachungseinrichtung 70 und die fehlersichere externe Peripheriebaugruppe 72, wirken dabei so zusammen, dass bei einer fehlerhaften Ausführung der die Sicherheitsfunktion realisierenden Anwenderprogramme 74, bei fehlerhaften Verhalten der Plattform selbst oder bei Fehlern in der Kommunikation mit dieser ein sicherer Zustand durch die sichere Einrichtung 100 herbeigeführt wird. Hierzu sichert die Überwachungseinrichtung 70 die Ausführung der Anwenderprogramme 74 ab. Hierfür kann die Überwachungseinrichtung 70 mit einer sicheren Laufzeitumgebung 76, welche auf der Plattform 68 ausgeführt wird, zusammenarbeiten.

Im Fehlerfall kann die Überwachungseinrichtung 70 über einen separaten und von der Plattform 68 unabhängig ausgeführten sicheren Dienst nach dem Prinzip eines "Watchdog" die Ausführung der Sicherheitsfunktion unabhängig von der Plattform 68 über die fehlersichere Peripheriebaugruppe 72 veranlassen, insbesondere eine zu überwachende technische Anlage oder einen sicherheitskritischen Prozess stillsetzen.

Die Plattform 68 kann eine Software-, Hardware- oder virtuelle Plattform sein, die als Basis für die Entwicklung und Ausführung darauf aufsetzender Anwenderprogramme 74 dient. Insbesondere kann die Plattform 68 eine nicht sichere Plattform sein, bspw. ein einkanaliges System wie ein handelsüblicher PC. Alternativ kann die Plattform 68 auch in Form von Cloud-Computing bereitgestellt werden, insbesondere als *Infrastructure as* a *Service (IaaS)* oder *Platform as* a *Service (PaaS).* Die Plattform 68 kann in einer bevorzugten Ausgestaltung bereits eine sichere Laufzeitumgebung 76 umfassen. Nicht sicher bedeutet in diesem Zusammenhang, dass die nicht sichere Plattform 68 für sich nicht den einschlägigen sicherheitstechnischen Anforderung genügt, um alleinstehend eine Sicherheitsfunktion mit dem geforderten Maß an Eigenfehlersicherheit auszuführen.

Die Überwachungseinrichtung 70 kann einen fehlersicheren Dienst 78 ausführen, der mit der sicheren Laufzeitumgebung 76 der Plattform und der fehlersicheren Peripheriebaugruppe 72 zusammenwirkt. Der fehlersichere Dienst kann bspw. einfache datentechnische Funktionen oder Operationen implementieren, die zuverlässig und fehlersicher in Hardware oder Software realisierbar sind. Diese lassen sich mit geringem Aufwand gemäß der einschlägigen Sicherheitsnormen zertifizieren. Mit anderen Worten kann eine derartige Überwachungseinrichtung 70 auf einfache Weise auch für hohe Sicherheitskategorien der einschlägigen Normen zugelassen werden.

Die Überwachungseinrichtung 70 ist somit in ihrem Umfang auf das Notwendigste zur exklusiven Ausführung des mindestens einen fehlersicheren Dienstes beschränkt. Die Überwachungseinrichtung 70 kann dementsprechend weniger komplex als die Sicherheitsfunktion-ausführende Plattform 68 ausgebildet sein, wodurch sich insbesondere eine sicherheitstechnische Abnahme durch die zuständigen Behörden vereinfachen lässt. Besonders vorteilhaft ist die sicherheitstechnische Absicherung unabhängig von der zu implementierenden Sicherheitsfunktion. Dadurch kann eine sicherheitstechnische Abnahme im Wesentlichen unabhängig von der im Einzelfall realisierten Sicherheitsfunktion erfolgen.

Das Auslösen der Sicherheitsfunktion selbst kann von der Überwachungseinrichtung 70 initiiert werden, während die Ausführung der fehlersicheren Peripheriebaugruppe 72 überlassen wird. Eine fehlersichere Peripheriebaugruppe 72 ist auf Standardkomponenten aufbauenden Automatisierungssystemen ohnehin vorhanden und an sich aus dem Stand der Technik bekannt.

Bestandteil der sicheren, externen Komponenten ist, um auch hohe Sicherheitskategorien ermöglichen zu können, eine sichere Spannungsüberwachung. Diese kann für die Überwachungseinrichtung 70 und die fehlersichere Peripheriebaugruppe 72 durch eine Vorrichtung 10 gemäß der vorliegenden Offenbarung sichergestellt werden. Ergänzend kann auch die Plattform 68 über eine derart ausgebildete Vorrichtung verfügen. Da somit für die Ausgestaltung einer in mehrere Komponenten zergliederten sicheren Einrichtung 100 mehrere derartige Vorrichtungen benötigt werden, ist eine kostengünstige und effektive Ausgestaltung dieser besonders vorteilhaft.

Die Vorrichtung kann in allen drei Komponenten identisch ausgebildet sein. Die Schnittstellen der Vorrichtung jedoch können auf unterschiedliche Weise mit der sicheren Einrichtung 100 gekoppelt sein. Beispielsweise kann in der Überwachungseinrichtung 70 die Vorrichtung 10 zur sicheren Spannungsüberwachung über die erste und zweite Schnittstelle direkt mit in der Überwachungseinrichtung 70 vorhandenen redundanten Verarbeitungseinheiten 80 gekoppelt sein, um die Vorrichtung 10, d.h. die sichere Spannungsüberwachung, zweikanalig zu testen. Die Verarbeitungseinheiten 80 der Überwachungseinrichtung 70 können einfache Mikrocontroller, ASICs oder ähnliche Recheneinheiten umfassen, oder aber aus diskreten elektrischen Bauteilen zusammengesetzt sein.

In der fehlersicheren Peripheriebaugruppe 72 kann die Vorrichtung 10 zur sicheren Spannungsüberwachung auf gleiche Weise implementiert sein, wie in der Überwachungseinrichtung 70. Alternativ oder ergänzend kann die Vorrichtung 10 sowohl in der Überwachungseinrichtung 70 als auch in der fehlersicheren Peripheriebaugruppe 72 anstelle mit integrierten Verarbeitungseinheiten 80 auch mit den redundant ausgeführten Anwenderprogrammen 74a, 74b verknüpft werden, welche in diesem Fall die Überprüfung der Spannungsüberwachung initiieren.

Die Überwachungseinrichtung 70 sowie die fehlersichere Peripheriebaugruppe 72 sind über eine Kommunikationsschnittstelle 82 mit der Plattform 68 verbunden. Diese Kommunikationsschnittstelle 82 muss keine sichere Kommunikationsschnittstelle sein, sondern kann als einfache USB-Schnittstelle ausgebildet sein.

In einem bevorzugten Ausführungsbeispiel kann die Überwachungseinrichtung 70 über eine USB-Schnittstelle auch mit einer Betriebsspannung versorgt werden. Die Betriebsspannung ist in diesem Fall die Eingangsspannung der Vorrichtung 10, die durch diese in die definierte Ausgangsspannung für den Betrieb der Verarbeitungseinheiten 80 gewandelt wird. Auf diese Weise kann die Überwachungseinrichtung 70 einschließlich der Vorrichtung 10 als einfacher USB-Dongle ausgebildet sein, der neben der USB-Schnittstelle keine weiteren Schnittstellen, zumindest nach außen, umfasst. Die Überwachungseinrichtung 70 einschließlich der sicheren Spannungsüberwachung kann so besonders einfach kostengünstig implementiert und eingesetzt werden.

Alternativ kann die Vorrichtung auch eine andere Betriebsspannung verwenden, bspw. kann die Vorrichtung 10 als Eingangsspannung im Falle der sicheren Peripheriebaugruppe 72 auch die zum Ansteuern der sicheren Ausgänge 84 verwendeten Betriebsspannung, in der Regel 24 V, als Eingangsspannung verwenden.

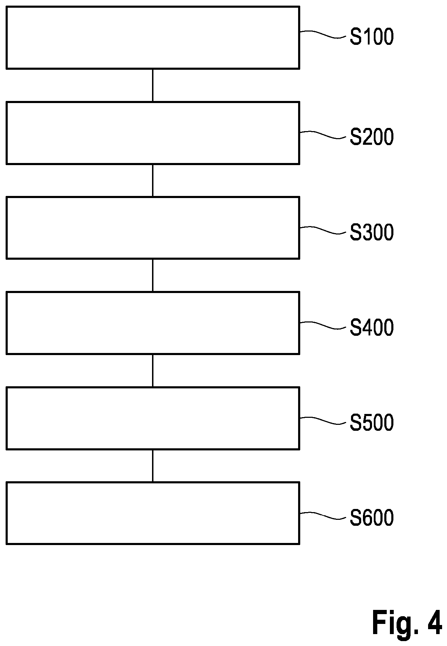

Fig. 4 zeigt in einem Flussdiagramm die einzelnen Schritte des Verfahrens zur Spannungsüberwachung einer Einrichtung, die eine Sicherheitsfunktion einer Maschine oder technischen Anlage realisiert und mindestens zwei Verarbeitungskanäle aufweist.

Schritt S100 umfasst das Aufnehmen einer Eingangsspannung an einem Eingang. Im Schritt S200 wird aus der Eingangsspannung über einen Spannungsregler eine definierte Ausgangsspannung erzeugt. Diese wird im Schritt S300 für den Betrieb der Einrichtung an einem Ausgang bereitgestellt. Gemäß der Schritte S100, S200 und S300 wird somit eine externe Betriebsspannung in eine für den Betrieb notwendige Ausgangsspannung transformiert.

Im Schritt S400 wird die am Ausgang anliegende Spannung mit der definierten Ausgangsspannung durch einen Spannungsmonitor verglichen. Weicht die anliegende Spannung von der definierten Ausgangsspannung ab, so wird im Schritt S400 der Ausgang abgeschaltet. Gemäß der Schritte S300 und S400 wird somit sichergestellt, dass entweder die definierte Ausgangsspannung (zumindest in einem definierten Toleranzbereich) am Ausgang anliegt oder aber keine Ausgangsspannung am Ausgang abgegriffen werden kann.

Im Schritt S500 werden eine erste und eine zweite Schnittstelle bereitgestellt, über die der Spannungsregler mit den mindestens zwei Verarbeitungskanälen der Einrichtung gekoppelt ist. Die erste und die zweite Schnittstelle sind dabei so ausgebildet, dass sie einen ersten und einen zweiten Verarbeitungskanal der mindestens zwei Verarbeitungskanäle der Einrichtung getrennt voneinander mit dem Spannungsregler koppeln. Mit anderen Worten ist es möglich, über die zwei Schnittstellen unabhängig voneinander Einfluss auf den Spannungsregler zu nehmen.

Im Schritt S600 wird anschließend der Spannungsregler verstimmt, um die Funktionsfähigkeit des Spannungsmonitors und damit die in den Schritten S100 bis S300 sichere Spannungsbereitstellung zu überprüfen.

Es versteht sich, dass das Verfahren weitere Schritte umfassen kann und nicht auf die hier beschriebene Reihenfolge der einzelnen Schritte festgelegt ist.

Gemäß einer bevorzugten Ausführungsform kann ein Test der Spannungsüberwachung wie folgt, insbesondere zyklisch, durchgeführt werden. Bei jedem Test wird abwechselnd eine Unterspannung und eine Überspannung erzeugt und überprüft, ob sich eine Erwartungshaltung einstellt, bspw. indem bestimmt wird, ob die Spannung am Ausgang des Spannungsmonitors unter eine definierte Schwelle fällt. Falls ja, ist der Spannungstest erfolgreich und die Betriebsspannung kann wieder am Spannungsregler eingestellt werden. Da bei ordnungsgemäßen Betrieb der Ausgang tatsächlich abgeschaltet werden würde, kann eine Kondensator vorgesehen sein, der trotz abgeschalteten Ausgang dafür sorgt, dass das System für eine definierte Zeitspanne weiter "lebt". Die Kapazität des Kondensator ist vorzugweise so dimensioniert, dass das System ca. 10ms mit abgeschalteter Spannungsversorgung überbrücken kann. Nach einem Test wird dann kurze Zeit gewartet, bis sich der Kondensator wieder aufgeladen hat, um den nächsten Test durchführen zu können.

Falls ein Test erfolgreich war kann der Normalbetrieb wieder eingestellt werden. Falls der Test nicht erfolgreich war, kann das Ergebnis bspw. in EEPROMs der Mikrocontroller vermerkt werden oder an eine übergeordnete Einheit als Diagnosemeldung weitergeleitet werden.

## Patentansprüche

1. Vorrichtung (10) zur Spannungsüberwachung einer Einrichtung (100), die eine Sicherheitsfunktion einer Maschine oder technischen Anlage realisiert oder überwacht und mindestens zwei Verarbeitungskanäle (12, 14) aufweist, umfassend:
einen Eingang (16) zum Aufnehmen einer Eingangsspannung (18),
einen Spannungsregler (20) zum Erzeugen einer definierten Ausgangsspannung (22) aus der Eingangsspannung (18),
einen Ausgang (24) zum Bereitstellen der definierten Ausgangsspannung (22) für den Betrieb der Einrichtung (100),
einen Spannungsmonitor (26), der eingerichtet ist, eine am Ausgang (24) anliegende Spannung mit der definierten Ausgangsspannung (22) zu vergleichen, sowie
eine erste Schnittstelle (28) und eine zweite Schnittstelle (30) zum Koppeln des Spannungsreglers (20) mit den mindestens zwei Verarbeitungskanälen (12, 14) der Einrichtung (100),
wobei die erste Schnittstelle (28) und die zweite Schnittstelle (30) eingerichtet sind, einen ersten Verarbeitungskanal (12) und einen zweiten Verarbeitungskanal (14) der mindestens zwei Verarbeitungskanäle der Einrichtung (100) getrennt voneinander mit dem Spannungsregler (20) zu koppeln,
**dadurch gekennzeichnet, dass** der Spannungsregler (20) einstellbar ist, so dass dessen Ausgangsspannung durch eine spezifische Ansteuerung über die erste Schnittstelle (28) und die zweite Schnittstelle (30) veränderbar ist, um einerseits eine Unterspannung, die kleiner als die definierte Ausgangsspannung ist, und andererseits eine Überspannung, die größer als die definierte Ausgangsspannung ist, bereitzustellen, und dass der Spannungsmonitor (26) bei einer Abweichung der anliegenden Spannung von der definierten Ausgangsspannung dazu eingerichtet ist, den Ausgang (24) abzuschalten.

2. Vorrichtung nach Anspruch 1, wobei ein Abschalten des Ausgangs (24) durch den Spannungsmonitor (26) zum Ausführen der Sicherheitsfunktion führt.

3. Vorrichtung nach einem der Ansprüche 1 oder 2, wobei der Spannungsregler (20) mit einem Widerstandsnetzwerk (40) gekoppelt ist und ein Verstimmen des Spannungsreglers (20) beinhaltet, die definierte Ausgangsspannung (22) des Spannungsreglers (20) über das Widerstandsnetzwerk (40) einzustellen.

4. Vorrichtung nach einem der vorherigen Ansprüche, wobei die Vorrichtung ferner ein erstes Schaltelement (42) und ein zweites Schaltelement (44) aufweist, die je in Abhängigkeit eines an der ersten Schnittstelle (28) oder zweiten Schnittstelle (30) anliegenden Signals betätigbar sind, wobei ein Verstimmen des Spannungsreglers (20) durch ein Betätigen des ersten Schaltelements (42) oder des zweiten Schaltelements (44) erfolgt.

5. Vorrichtung nach Anspruch 4, wobei das Betätigen des ersten Schaltelements (42) und des zweiten Schaltelements (44) die am Ausgang anliegende Spannung um einen definierten Betrag ändert, insbesondere senkt.

6. Vorrichtung nach einem der Ansprüche 4 oder 5, wobei, wenn das erste Schaltelement (42) betätigt ist und das zweite Schaltelement (44) nicht betätigt ist, der Spannungsregler (20) die definierte Ausgangsspannung (22) bereitstellt, wenn das erste Schaltelement (42) und das zweite Schaltelement (44) betätigt sind, der Spannungsregler (20) eine definierte Unterspannung, kleiner als die definierte Ausgangsspannung (22), bereitstellt, und wenn das erste Schaltelement (42) nicht betätigt ist und das zweite Schaltelement (44) betätigt ist, der Spannungsregler (20) eine definierte Überspannung, größer als die definierte Ausgangsspannung, bereitstellt.

7. Vorrichtung nach einem der vorherigen Ansprüche, wobei die Vorrichtung ferner einen Kondensator (66) aufweist, der am Ausgang (24) angeordnet ist und dazu eingerichtet ist, die definierte Ausgangsspannung (22) für eine definierte Zeitspanne zu halten, wenn der Spannungsmonitor (26) den Ausgang (24) abschaltet.

8. Vorrichtung nach einem der vorherigen Ansprüche, wobei die Vorrichtung ferner eine dritte Schnittstelle (62) und eine vierte Schnittstelle (64) aufweist, die mit dem ersten Verarbeitungskanal (12) und dem zweiten Verarbeitungskanal (14) getrennt voneinander koppelbar sind und an denen die am Ausgang anliegende Spannung abgreifbar ist.

9. Einrichtung zur Realisierung oder Überwachung einer Sicherheitsfunktion einer Maschine oder technischen Anlage, insbesondere ein Sicherheitsschaltgerät, umfassend
einen ersten Mikrocontroller, der einen ersten Verarbeitungskanal (12) definiert,
eine zweiten Mikrocontroller, der einen zweiten Verarbeitungskanal (14) definiert, sowie
eine Vorrichtung nach einem der Ansprüche 1 bis 8.

10. Einrichtung nach Anspruch 9, wobei die Einrichtung eine Kommunikationsschnittstelle (82), insbesondere eine USB-Schnittstelle aufweist, die eine Betriebsspannung als Eingangsspannung (18) bereitstellt.

11. Einrichtung nach Anspruch 10, wobei die Realisierung oder Überwachung der Sicherheitsfunktion über die Kommunikationsschnittstelle (82) erfolgt.

12. Einrichtung nach einem der Ansprüche 9 bis 11, wobei die Einrichtung als Dongle, insbesondere als USB-Stick, ausgebildet ist und ein Gehäuse umfasst, in dem der erste Mikrocontroller und der zweite Mikrocontroller eingefasst sind.

13. Einrichtung, nach einem der Ansprüche 9 bis 12, wobei die Einrichtung eine Überwachungseinrichtung ist, die eingerichtet ist, die Ausführung einer aus Anwenderprogrammen realisierten Sicherheitsfunktion auf einer Plattform (68) zu sichern, wobei die Überwachungseinrichtung (70) über eine erste Kommunikationsschnittstelle mit der Plattform koppelbar ist und mindestens einen fehlersicheren Dienst (78) unabhängig von der Plattform (68) ausführt, über den die Überwachungseinrichtung (70) mit einer fehlersicheren Peripheriebaugruppe (72) zusammenwirkt, so dass die fehlersichere Peripheriebaugruppe (72) in Abhängigkeit von der realisierten Sicherheitsfunktion auf der Plattform (68) und dem fehlersicheren Dienst (78) einen sicheren Zustand der Maschine oder technischen Anlage herbeiführt.

14. Verfahren zur Spannungsüberwachung einer Einrichtung, die eine Sicherheitsfunktion einer Maschine oder technischen Anlage realisiert oder überwacht und mindestens zwei Verarbeitungskanäle aufweist, mit den Schritten:
- Aufnehmen einer Eingangsspannung (18) an einem Eingang (16);
- Erzeugen einer definierten Ausgangsspannung (22) aus der Eingangsspannung (18) mit einem Spannungsregler (20);
- Bereitstellen der definierten Ausgangsspannung (22) an einem Ausgang (24) für den Betrieb der Einrichtung;
- Vergleichen einer am Ausgang (24) anliegenden Spannung mit der definierten Ausgangsspannung (22) durch einen Spannungsmonitor (26); sowie
- Koppeln des Spannungsreglers (20) mit den mindestens zwei Verarbeitungskanälen der Einrichtung über eine erste Schnittstelle (28) und eine zweite Schnittstelle (30), wobei die erste Schnittstelle (28) und die zweite Schnittstelle ( 30) einen ersten Verarbeitungskanal (12) und einen zweiten Verarbeitungskanal (14) der mindestens zwei Verarbeitungskanäle der Einrichtung getrennt voneinander mit dem Spannungsregler (20) koppeln
**dadurch gekennzeichnet, dass**
der Spannungsregler (20) einstellbar ist, so dass dessen Ausgangsspannung durch eine spezifische Ansteuerung über die erste Schnittstelle (28) und die zweite Schnittstelle (30) veränderbar ist, um einerseits eine Unterspannung, die kleiner als die definierte Ausgangsspannung ist, und andererseits eine Überspannung, die größer als die definierte Ausgangsspannung ist, bereitzustellen, und dass der Spannungsmonitor (26) bei einer Abweichung der anliegenden Spannung von der definierten Ausgangsspannung den Ausgang (24) abschaltet.

15. Computerprogram, umfassend Befehle, die bei der Ausführung des Programms durch einen Computer diesen veranlassen, die Schritte des Verfahrens nach Anspruch 14 auszuführen.

## Claims

1. Apparatus (10) for voltage monitoring of a device (100) which implements or monitors a safety function of a machine or technical installation and has at least two processing channels (12, 14), comprising:
an input (16) for receiving an input voltage (18),
a voltage regulator (20) for generating a defined output voltage (22) from the input voltage (18),
an output (24) for providing the defined output voltage (22) for the operation of the device (100),
a voltage monitor (26) configured to compare a voltage, which is present at the output (24), with the defined output voltage (22), and
a first interface (28) and a second interface (30) for connecting said voltage regulator (20) to the at least two processing channels (12, 14) of the device (100),
wherein the first interface (28) and the second interface (30) are configured to connect a first processing channel (12) and a second processing channel (14) of the at least two processing channels of the device (100) separately with the voltage regulator (20),
**characterized in that** the voltage regulator (20) is adjustable so that its output voltage can be adjusted by a specific control of the first interface (28) and the second interface (30) in such a way that on the one hand an undervoltage, which is smaller than the defined output voltage, and on the other hand an overvoltage, which is larger than the defined output voltage, is provided, and **in that** the voltage monitor (26) is configured to switch off the output (24) in the event that the voltage, which is present at the output (24), deviates from the defined output voltage.

2. The apparatus according to claim 1, wherein switching off the output (24) by the voltage monitor (26) results in execution of the safety function.

3. The apparatus according to claims 1 or 2, wherein the voltage regulator (20) is connected to a resistor network (40) and detuning the voltage regulator (20) includes adjusting the defined output voltage (22) of the voltage regulator (20) via the resistor network (40).

4. The apparatus according to any one of the preceding claims, wherein the apparatus further comprises a first switching element and a second switching element (42, 44) each operable in response to a signal present at the first interface or at the second interface (28, 30), and wherein detuning of the voltage regulator (20) is achieved by actuation of the first switching element or the second switching element (42, 44).

5. The apparatus according to claim 4, wherein actuation of the first switching element (42) and the second switching element (44) changes the voltage present at the output by a defined amount, in particular reduces it.

6. The apparatus according to claims 4 or 5, wherein, when the first switching element (42) is actuated and the second switching element (44) is not actuated, the voltage regulator (20) provides the defined output voltage (22), when the first switching element (42) and the second switching element (44) are actuated, the voltage regulator (20) provides a defined undervoltage less than the defined output voltage (22), and, when the first switching element (42) is not actuated and the second switching element (44) is actuated, the voltage regulator (20) provides a defined overvoltage greater than the defined output voltage.

7. The apparatus according to any one of the preceding claims, wherein the apparatus further comprises a capacitor (66) disposed at the output (24) and configured to hold the defined output voltage (22) for a defined period of time when the voltage monitor (26) switches off the output (24).

8. The apparatus according to any one of the preceding claims, wherein the apparatus further comprises a third interface (62) and a fourth interface (64) which are separately connectable to the first processing channel (12) and the second processing channel (14) and at which the voltage present at the output is accessible.

9. Device (100) for implementing or monitoring a safety function of a machine or technical installation, in particular a safety switching device, comprising:
a first microcontroller defining a first processing channel (12),
a second microcontroller defining a second processing channel (14), and
an apparatus according to any one of claims 1 to 8.

10. The device according to claim 9, wherein the device further comprises a communication interface (82), in particular a USB interface, which provides an operating voltage as input voltage (18).

11. The device according to claim 10, wherein the implementation or monitoring of the safety function is carried out via the communication interface (82).

12. The device according to any one of claims 9 to 11, wherein the device is designed as a dongle, in particular as a USB stick, and comprises a housing in which the first microcontroller and the second microcontroller are enclosed.

13. The device according to any one of claims 9 to 12, wherein the device is a monitoring device configured to safeguard the execution of a safety function implemented by user programs on a platform (68), the monitoring device (70) being connectable to the platform via a first communication interface and executing at least one fail-safe service (78) independently of the platform (68), via which the monitoring device (70) cooperates with a fail-safe peripheral module (72), so that the fail-safe peripheral module (72) puts the machine or technical installation into a safe state based on the implemented safety function on the platform (68) and the fail-safe service (78).

14. Method for monitoring the voltage of a device (100) which implements or monitors a safety function of a machine or technical installation and has at least two processing channels, the method comprising the steps:
- Receiving an input voltage (18) at an input (16);
- Generating, by a voltage regulator (20), a defined output voltage (22) from the input voltage (18);
- Providing the defined output voltage (22) at an output (24) for the operation of the device;
- Comparing a voltage present at the output (24) with the defined output voltage (22) by means of a voltage monitor (26);
- Connecting the voltage regulator (20) to the at least two processing channels of the device via a first interface (28) and a second interface (30), wherein the first interface (28) and the second interface (30) connect to a first processing channel (12) and a second processing channel (14) of the at least two processing channels of the device (100) separately (20);
**characterized in that** the voltage regulator (20) is adjustable so that its output voltage can be adjusted by a specific control of the first interface (28) and the second interface (30) in such a way that on the one hand an undervoltage, which is smaller than the defined output voltage, and on the other hand an overvoltage, which is larger than the defined output voltage, is provided, and **in that** the voltage monitor (26) switches off the output (24) in the event that the voltage, which is present at the output (24), deviates from the defined output voltage.

15. A computer program comprising instructions which, when the program is executed by a computer, cause the computer to execute the steps of the method according to claim 14.

## Revendications

1. Dispositif (10) de surveillance de tension d'un équipement (100) qui réalise ou surveille une fonction de sécurité d'une machine ou d'une installation technique et présente au moins deux canaux de traitement (12, 14), comprenant :
une entrée (16) pour recevoir une tension d'entrée (18),
un régulateur de tension (20) pour générer une tension de sortie définie (22) à partir de la tension d'entrée (18),
une sortie (24) pour fournir la tension de sortie définie (22) pour le fonctionnement de l'équipement (100),
un moniteur de tension (26) qui est aménagé pour comparer une tension appliquée à la sortie (24) avec la tension de sortie définie (22), et
une première interface (28) et une deuxième interface (30) pour coupler le régulateur de tension (20) avec les au moins deux canaux de traitement (12, 14) de l'équipement (100),
la première interface (28) et la deuxième interface (30) étant aménagées pour coupler un premier canal de traitement (12) et un deuxième canal de traitement (14) des au moins deux canaux de traitement de l'équipement (100) séparément l'un de l'autre avec le régulateur de tension (20),
**caractérisé en ce que** le régulateur de tension (20) est réglable de sorte que sa tension de sortie peut être modifiée par un pilotage spécifique par le biais de la première interface (28) et de la deuxième interface (30) afin de fournir d'une part une sous-tension qui est inférieure à la tension de sortie définie, et d'autre part une surtension qui est supérieure à la tension de sortie définie, et **en ce que** le moniteur de tension (26) est aménagé pour déconnecter la sortie (24) si la tension appliquée dévie de la tension de sortie définie.

2. Dispositif selon la revendication 1, dans lequel une déconnexion de la sortie (24) par le moniteur de tension (26) entraîne l'exécution de la fonction de sécurité.

3. Dispositif selon l'une quelconque des revendications 1 et 2, dans lequel le régulateur de tension (20) est couplé avec un réseau de résistances (40), et le fait de désaccorder le régulateur de tension (20) comporte le réglage de la tension de sortie définie (22) du régulateur de tension (20) par l'intermédiaire du réseau de résistances (40).

4. Dispositif selon l'une quelconque des revendications précédentes, le dispositif présentant en outre un premier et un deuxième élément de commutation (42, 44) qui peuvent être actionnés respectivement en fonction d'un signal appliqué à la première interface (28) ou à la deuxième interface (30), le régulateur de tension (20) étant désaccordé par un actionnement du premier élément de commutation (42) ou du deuxième élément de commutation (44).

5. Dispositif selon la revendication 4, dans lequel l'actionnement du premier élément de commutation (42) et du deuxième élément de commutation (44) modifie la tension appliquée à la sortie d'une quantité définie, en particulier la diminue.

6. Dispositif selon l'une quelconque des revendications 4 et 5, dans lequel le régulateur de tension (20) fournit la tension de sortie définie (22) lorsque le premier élément de commutation (42) est actionné et le deuxième élément de commutation (44) n'est pas actionné, le régulateur de tension (20) fournit une sous-tension définie qui est inférieure à la tension de sortie définie (22) lorsque le premier élément de commutation (42) et le deuxième élément de commutation (44) sont actionnés, et le régulateur de tension (20) fournit une surtension définie supérieure à la tension de sortie définie lorsque le premier élément de commutation (42) n'est pas actionné et le deuxième élément de commutation (44) est actionné.

7. Dispositif selon l'une quelconque des revendications précédentes, le dispositif présentant un condensateur (66) qui est disposé à la sortie (24) et qui est aménagé pour maintenir la tension de sortie définie (22) pendant une période définie si le moniteur de tension (26) déconnecte la sortie (24).

8. Dispositif selon l'une quelconque des revendications précédentes, le dispositif présentant en outre une troisième interface (62) et une quatrième interface (64) qui peuvent être couplées séparément l'une de l'autre au premier canal de traitement (12) et au deuxième canal de traitement (14) et auxquelles la tension appliquée à la sortie peut être prélevée.

9. Équipement permettant de réaliser ou de surveiller une fonction de sécurité d'une machine ou d'une installation technique, en particulier d'un appareil de commutation de sécurité, comprenant
un premier microcontrôleur qui définit un premier canal de traitement (12),
un deuxième microcontrôleur qui définit un deuxième canal de traitement (14), et
un dispositif selon l'une quelconque des revendications 1 à 8.

10. Équipement selon la revendication 9, l'équipement présentant une interface de communication (82), en particulier une interface USB, qui fournit une tension de fonctionnement comme tension d'entrée (18).

11. Équipement selon la revendication 10, dans lequel la réalisation ou la surveillance de la fonction de sécurité est effectuée par le biais de l'interface de communication (82).

12. Équipement selon l'une quelconque des revendications 9 à 11, l'équipement étant réalisé sous forme de clé électronique, en particulier de clé USB, et comprenant un boîtier qui entoure le premier microcontrôleur et le deuxième microcontrôleur.

13. Équipement, selon l'une quelconque des revendications 9 à 12, l'équipement étant un équipement de surveillance qui est aménagé pour sécuriser l'exécution d'une fonction de sécurité réalisée par des programmes d'utilisateur sur une plate-forme (68), l'équipement de surveillance (70) pouvant être couplé avec la plate-forme par une première interface de communication et exécutant au moins un service à sécurité intégrée (78) indépendamment de la plate-forme (68) par lequel l'équipement de surveillance (70) coopère avec le module périphérique à sécurité intégrée (72) de sorte qu'en fonction de la fonction de sécurité réalisée sur la plate-forme (68) et du service à sécurité intégrée (78), le module périphérique à sécurité intégrée (72) entraîne un état sécurisé de la machine ou de l'installation technique.

14. Procédé de surveillance de tension d'un équipement qui réalise ou surveille une fonction de sécurité d'une machine ou d'une installation technique et présente au moins deux canaux de traitement, comprenant les étapes consistant à :
- recevoir une tension d'entrée (18) à une entrée (16) ;
- générer une tension de sortie définie (22) à partir de la tension d'entrée (18) avec un régulateur de tension (20) ;
- fournir la tension de sortie définie (22) à une sortie (24) pour le fonctionnement de l'équipement;
- comparer une tension appliquée à la sortie (24) avec la tension de sortie définie (22) par un moniteur de tension (26) ; et
- coupler le régulateur de tension (20) avec les au moins deux canaux de traitement de l'équipement par le biais d'une première interface (28) et d'une deuxième interface (30), la première interface (28) et la deuxième interface (30) couplant séparément l'une de l'autre un premier canal de traitement (12) et un deuxième canal de traitement (14) des au moins deux canaux de traitement de l'équipement avec le régulateur de tension (20),
**caractérisé en ce que** le régulateur de tension (20) est réglable de sorte que sa tension de sortie peut être modifiée par un pilotage spécifique par le biais de la première interface (28) et de la deuxième interface (30) afin de fournir d'une part une sous-tension qui est inférieure à la tension de sortie définie, et d'autre part une surtension qui est supérieure à la tension de sortie définie, et **en ce que** le moniteur de tension (26) est aménagé pour déconnecter la sortie (24) si la tension appliquée dévie de la tension de sortie définie.

15. Programme informatique, comprenant des instructions qui, lors de l'exécution du programme par un ordinateur, ont pour effet que celui-ci exécute les étapes du procédé selon la revendication 14.
